# EUROPÄISCHE PATENTSCHRIFT

(11) **EP 2 526 545 B1**
(45) Veröffentlichungstag und Bekanntmachung des Hinweises auf die Patenterteilung: **20.07.2016**
(21) Anmeldenummer: 11700919.1
(22) Anmeldetag: 14.01.2011
(51) Int. Cl.: H01L 23/538, H05K 1/18, H01L 23/31

(54) **SENSOR MIT DÄMPFUNG**
ENCODER WITH ATTENUATION
CAPTEUR A ATTENUATION

(30) Priorität: 19.01.2010 DE 102010001023
(43) Veröffentlichungstag der Anmeldung: 28.11.2012
(73) Patentinhaber: Robert Bosch GmbH, 70442 Stuttgart (DE)
(72) Erfinder: JOBERT, Tristan, 72766 Reutlingen (DE); HANSEN, Uwe, 72770 Reutlingen (DE)
(86) Internationale Anmeldenummer: PCT/EP2011/050437
(87) Internationale Veröffentlichungsnummer: WO 2011/089066

(56) Entgegenhaltungen:
- EP-A1- 0 660 081
- EP-A1- 0 806 589
- DE-A1-102007 011 170
- US-A- 5 025 666

## Beschreibung

Die vorliegende Erfindung betrifft eine Sensorvorrichtung aufweisend eine flexible Leiterplatte, eine auf einem Befestigungsabschnitt der flexiblen Leiterplatte angeordnete Chipstruktur und ein Dämpferelement zum Dämpfen der Chipstruktur gegenüber mechanischen Einflüssen. Die Erfindung betrifft des Weiteren ein Verfahren zum Herstellen einer Sensorvorrichtung.

### Stand der Technik

Sensorvorrichtungen, welche beispielsweise in Sicherheitssystemen von Kraftfahrzeugen eingesetzt werden, weisen üblicherweise eine Chipstruktur mit einem Sensorchip und einem mit dem Sensorchip elektrisch verbundenen Auswertechip auf. Der Sensorchip ist in Form eines mikromechanischen Bauelements (MEMS, Micro Electro Mechanical System) ausgebildet, um eine physikalische Messgröße wie zum Beispiel eine Beschleunigung oder eine Drehrate zu erfassen. Der Auswertechip dient zur Steuerung des Sensorchips und zur Auswertung bzw. Weiterverarbeitung von Messsignalen des Sensorchips.

Die Sensorvorrichtungen können je nach Verwendung ungedämpft oder gedämpft ausgebildet sein. Bei einer bekannten gedämpften Ausführungsform sind die Chips auf einer Bodenplatte vorgesehen, welche innerhalb eines rahmenförmigen Gehäusegrundkörpers (Premold-Rahmen) angeordnet ist. Die Bodenplatte ist am Rand von einem elastischen Dämpferelement umgeben und durch das Dämpferelement innenseitig an dem Gehäuserahmen angebunden. Auf diese Weise ist die Bodenplatte gegenüber dem Gehäuserahmen auslenkbar, wodurch eine Dämpfung der Chips gegenüber äußeren mechanischen Einflüssen wie zum Beispiel Stößen oder Vibrationen ermöglicht wird. Der Gehäuserahmen weist Kontaktelemente auf, über welche die Sensorvorrichtung von extern kontaktierbar ist. Die Kontaktelemente sind innerhalb des Gehäuserahmens über Bonddrähte elektrisch mit dem Auswertechip verbunden.

Bei der bekannten Sensorvorrichtung kann das Problem bestehen, dass die Dämpfung nur bei bestimmten Frequenzen wirkt, wodurch Vibrationen zu Störungen des Sensorchips und damit der Messsignale führen können. Die Dämpfungseigenschaften sind abhängig von der Geometrie des Dämpferelements und den Materialeigenschaften des Dämpfermaterials (üblicherweise Silikon). Neben der geforderten Elastizität unterliegt das Dämpfermaterial jedoch weiteren Anforderungen, so dass die Materialauswahl stark eingeschränkt ist. Beispielsweise wird gefordert, dass das Dämpfermaterial spritzbar ist, um eine einfache Verarbeitung zu ermöglichen, sowie eine gute Haftung in Bezug auf die Bodenplatte (z.B. Stahl) und den Gehäuserahmen (z.B. Kunststoff) aufweist. Auch können für die Entkopplung verschiedener Störfrequenzen jeweils eigene Gehäuse erforderlich sein, was mit einem hohen Kostenaufwand verbunden ist.

Der Aufbau der Sensorvorrichtung kann des Weiteren zu einer Beeinträchtigung bzw. Unterbrechung der elektrischen Verbindung führen. Stöße oder Beschleunigungen, welche beispielsweise bei einem Falltest oder einem unsachgemäßen Handling der Sensorvorrichtung vorkommen können, haben eine relativ große Auslenkung der Bodenplatte gegenüber dem Gehäuserahmen zur Folge. Dadurch entsteht eine entsprechende Relativbewegung in den Bonddrähten, welche an dem Auswertechip und an dem Gehäuserahmen befestigt sind. Hiermit verbunden sind Verwehungen der Bonddrähte bzw. ein Reißen oder Ablösen der Bonddrähte von ihren Kontaktstellen. Der im Wesentlichen horizontale Aufbau der Sensorvorrichtung hat ferner einen relativ großen lateralen Platzbedarf zur Folge. Auch sind Totflächen in Form von Abdichtungsflächen innerhalb des Gehäuserahmens bzw. um die Bodenplatte herum vorgesehen, wodurch die Grundfläche des Sensors (Footprint) deutlich größer ist als diejenige der Chips.

Aus der nicht veröffentlichten Patentanmeldung DE 10 2009 000 571.4 ist eine weitere gedämpfte Sensorvorrichtung bekannt, bei welcher eine elektrische Verbindung zwischen Kontaktelementen eines Gehäuserahmens und eines Auswertechips mit Hilfe einer flexiblen Leiterplatte hergestellt ist, um einen stoßunempfindlicheren Aufbau zu erzielen. In einer Ausführungsform weist die flexible Leiterplatte einen als Bodenteil dienenden Abschnitt auf, auf welcher die Chips angeordnet sind Das Bodenteil ist am Rand von einem elastischen Dämpferelement umgeben und durch das Dämpferelement innenseitig an dem Gehäuserahmen angebunden.

Die US 5 025 666 zeigt ein elektronisches Bauteil mit einer flexiblen Leiterplatte und einem Dämpferelement.

Die EP 0 660 081 A1 zeigt ein mittels Dämpferelementen vibrationsarm ausgeführtes elektronisches Bauteil.

Die DE 10 2007 011 170 A1 zeigt ebenfalls ein mittels Dämpferelementen vibrationsarm ausgeführtes elektronisches Bauteil.

Die EP 0 806 589 A1 zeigt ein elektronisches Bauteil mit einer flexiblen Leiterplatte.

### Offenbarung der Erfindung

Die Aufgabe der vorliegenden Erfindung besteht darin, eine verbesserte Sensorvorrichtung bereitzustellen, welche sich insbesondere durch einen stoßunempfindlichen Aufbau und einen kleinen lateralen Platzbedarf auszeichnet. Es ist ferner Aufgabe der Erfindung, ein Verfahren zum Herstellen einer solchen Sensorvorrichtung anzugeben.

Diese Aufgabe wird durch eine Sensorvorrichtung gemäß Anspruch 1 und durch ein Verfahren gemäß Anspruch 10 gelöst. Weitere vorteilhafte Ausführungsformen der Erfindung sind in den abhängigen Ansprüchen angegeben.

Erfindungsgemäß wird eine Sensorvorrichtung vorgeschlagen, welche eine flexible Leiterplatte mit einem Befestigungsabschnitt für eine Chipstruktur, eine auf dem Befestigungsabschnitt der flexiblen Leiterplatte angeordnete Chipstruktur und ein Dämpferelement zum Dämpfen der Chipstruktur gegenüber mechanischen Einflüssen aufweist. Der Befestigungsabschnitt der flexiblen Leiterplatte, die Chipstruktur und das Dämpferelement sind zueinander übereinander angeordnet.

Aufgrund der Übereinander-Anordnung des Befestigungsabschnitts der flexiblen Leiterplatte, der Chipstruktur und des Dämpferelements weist die Sensorvorrichtung einen relativ kleinen lateralen Platzbedarf auf. Die Verwendung der flexiblen Leiterplatte, über welche eine elektrische Verbindung zwischen der Chipstruktur und anderen Komponenten hergestellt werden kann, ermöglicht des Weiteren eine verbesserte Fallfestigkeit und Stoßunempfindlichkeit. Auch kann gegebenenfalls eine größere Auswahl an möglichen Materialien für das Dämpferelement zur Verfügung stehen.

In einer bevorzugten Ausführungsform weist die flexible Leiterplatte eine erste Seite und eine der ersten Seite gegenüberliegende zweite Seite auf. Die Chipstruktur ist auf der ersten Seite und das Dämpferelement auf der zweiten Seite der flexiblen Leiterplatte angeordnet.

In einer weiteren bevorzugten Ausführungsform grenzt das Dämpferelement an die Chipstruktur an. Hierbei kann ferner vorgesehen sein, dass das Dämpferelement die Chipstruktur zusätzlich umschließt. In dieser Ausgestaltung kann das Dämpferelement neben der Dämpferfunktion auch einen Schutz bzw. eine Passivierung der Chipstruktur ermöglichen.

Erfindungsgemäß weist die flexible Leiterplatte eine U-förmige Form mit einem ersten und einem zweiten Schenkel auf, welche einen Zwischenbereich einschließen. Auf diese Weise wird ein platzsparender Aufbau der Sensorvorrichtung weiter begünstigt.

In diesem Zusammenhang ist es erfindungsgemäß vorgesehen, dass das Dämpferelement in dem Zwischenbereich angeordnet ist. Möglich ist es auch, dass das Dämpferelement und die Chipstruktur in dem Zwischenbereich angeordnet sind.

In einer weiteren bevorzugten Ausführungsform ist der Befestigungsabschnitt der flexiblen Leiterplatte ein starrer Abschnitt. Auf diese Weise können ungehäuste Chips zuverlässig auf dem Befestigungsabschnitt der Leiterplatte angeordnet bzw. getragen werden.

Im Hinblick auf die Chipstruktur kommen unterschiedliche Ausführungsformen in Betracht. Die Chipstruktur kann zum Beispiel einen Sensorchip und einen Auswertechip umfassen.

Möglich ist auch ein Chipmodul, bei dem Chips in einem Gehäuse angeordnet sind. Hierbei kann mit Hilfe der Sensorvorrichtung eine (zusätzliche) Dämpfung des Chipmoduls bereitgestellt werden.

Erfindungsgemäß wird des Weiteren ein Verfahren zum Herstellen einer Sensorvorrichtung vorgeschlagen. Das Verfahren umfasst ein Bereitstellen einer flexiblen Leiterplatte, wobei die flexible Leiterplatte einen Befestigungsabschnitt für eine Chipstruktur aufweist, ein Anordnen einer Chipstruktur auf dem Befestigungsabschnitt der flexiblen Leiterplatte, und ein Ausbilden eines Dämpferelements derart, dass der Befestigungsabschnitt der flexiblen Leiterplatte, die Chipstruktur und das Dämpferelement zueinander übereinander angeordnet sind.

In entsprechender Weise bietet das Verfahren die Möglichkeit, eine gedämpfte Sensorvorrichtung mit einem kleinen lateralen Platzbedarf und einer hohen Stossunempfindlichkeit herzustellen. Auch kann eine Montage der Chipstruktur von einem Anbringen des Dämpferelements entkoppelt bzw. getrennt werden, wodurch sich eine hohe Flexibilität bei der Weiterverarbeitung erzielen lässt.

Die Erfindung wird im Folgenden anhand der Figuren näher erläutert. Es zeigen:
Figuren 1 und 2 die Herstellung einer Sensorvorrichtung, jeweils in einer schematischen seitlichen Darstellung; und
Figuren 3 bis 12 weitere Sensorvorrichtungen, jeweils in einer schematischen seitlichen Darstellung.

Die folgenden Figuren zeigen mögliche Ausführungsformen von Sensorvorrichtungen, welche auch als "Sensormodul" oder "Sensorpackage" bezeichnet werden. Die Sensorvorrichtungen ermöglichen eine effektive Dämpfung einer vibrationsempfindlichen Chipstruktur und zeichnen sich durch einen geringen Platzbedarf aus. Als Anwendungsgebiete der gezeigten Sensorvorrichtungen kommen beispielsweise Sicherheitssysteme von Kraftfahrzeugen wie zum Beispiel ESP (Elektronisches Stabilitätsprogramm) in Betracht. Hierbei kann es sich auch um solche ESP-Systeme handeln, bei denen die Sensorvorrichtungen in Steuergeräten (bzw. deren Gehäuse) von ABS-Systemen (Antiblockiersystem) integriert sind. Der Aufbau der Sensorvorrichtungen macht es möglich, im Betrieb der ABS-Steuergeräte auftretende Vibrationen sowie andere mechanische Störungen zuverlässig zu dämpfen.

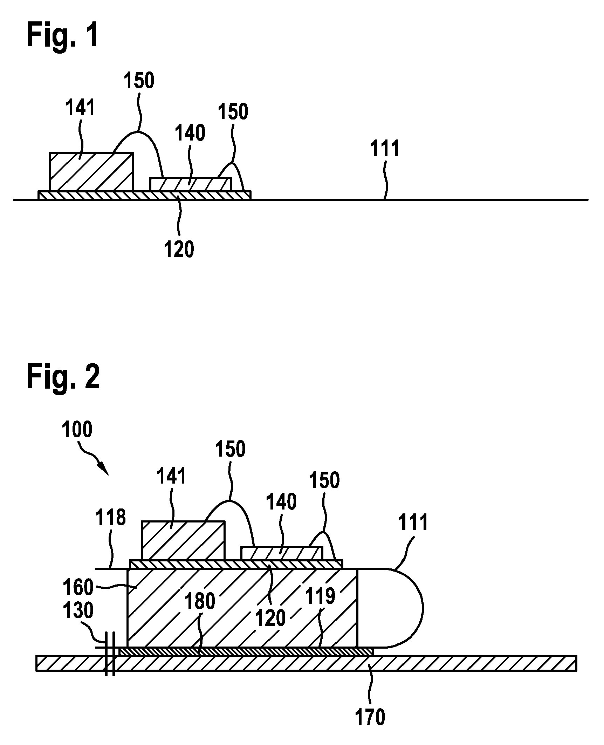

Die Figuren 1 und 2 zeigen die Herstellung einer Sensorvorrichtung 100, jeweils in einer seitlichen Schnittdarstellung. Bei dem Verfahren wird eine flexible Leiterplatte 111 bereitgestellt, auf welcher wie in Figur 1 dargestellt eine Chipstruktur angeordnet wird. Die flexible Leiterplatte 111 umfasst beispielsweise ein Band oder eine Folie aus einem flexiblen Kunststoffmaterial wie zum Beispiel Polyimid und hierauf angeordneten Leiterbahnen aus einem elektrisch leitfähigen bzw. metallischen Material (nicht dargestellt). Möglich ist auch der Einsatz von zwei Polyimidfolien und einer zwischen den Folien angeordneten Leiterbahnstruktur, oder einer Mehrlagen-Leiterplatte mit mehreren durch Polyimidfolien getrennten Leiterbahnebenen, welche durch eine entsprechende Verdrahtungsstruktur elektrisch verbunden sein können. Anstelle des Polyimids kann alternativ auch ein anderes flexibles bzw. formbares Kunststoffmaterial zum Einsatz kommen.

Neben elastischen Bereichen weist die flexible Leiterplatte 111 ferner einen starren Bereich 120 zum Tragen der Chipstruktur auf. Der Bereich 120, welcher im Folgenden als Befestigungsabschnitt 120 bezeichnet wird, kann beispielsweise wie in Figur 1 angedeutet in Form einer auf der bzw. auf den Folien der Leiterplatte 111 angeordneten starren Platte ausgebildet sein. Hierbei kann die starre Platte beispielsweise ein Keramikmaterial aufweisen.

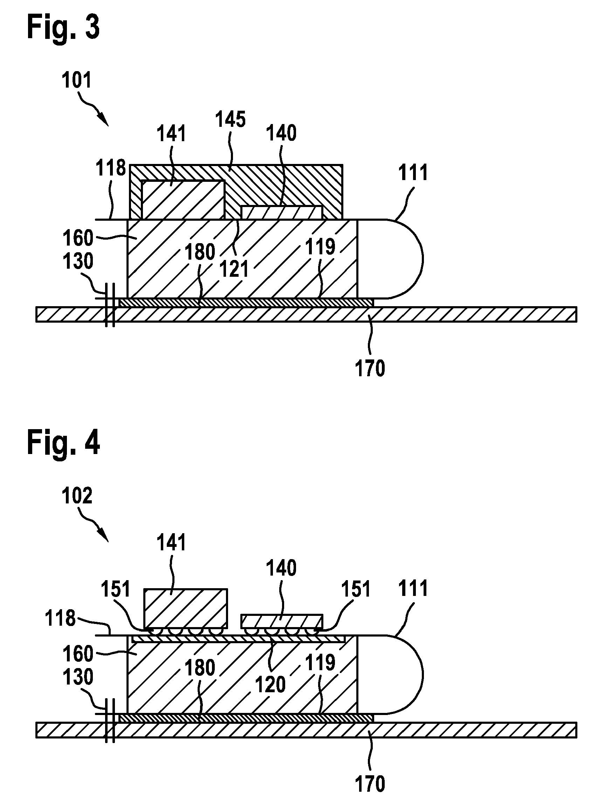

Alternativ kann die flexible Leiterplatte 111 mit dem starren Befestigungsabschnitt 120 auf andere Weise bereitgestellt werden. Eine Möglichkeit besteht beispielsweise darin, im Rahmen der Herstellung der Leiterplatte 111 eine Folie eines flexiblen Materials (zum Beispiel Polyimid) mit einer Schicht eines aushärtbaren Materials (zum Beispiel eines Harz-Glasfasergewebes) zu laminieren. Eine weitere mögliche Ausgestaltung besteht darin, eine starre Platte (zum Beispiel aus einem metallischen Material wie beispielsweise Stahl) zu verwenden und auf derjenigen Seite der flexiblen Leiterplatte 111 vorzusehen, welche der Seite der Leiterplatte 111, auf welcher die Chipstruktur angeordnet wird, gegenüberliegt (vergl. die Ausführungsform von Figur 4).

Um die flexible Leiterplatte 111 und deren Leiterbahnen elektrisch zu kontaktieren, ist der Befestigungsabschnitt 120 ferner an der Seite, an welcher die Chipstruktur angeordnet wird, mit entsprechenden Kontaktstellen versehen (nicht dargestellt). Die Kontaktstellen können insbesondere in Form von Kontaktflächen bzw. sogenannten "Bondpads" ausgebildet sein.

Als Chipstruktur für die Sensorvorrichtung 100 ist ein Auswertechip 140 und ein mikromechanischer Sensorchip 141 vorgesehen. Die beiden Chips 140, 141, bei denen es sich um ungehäuste Chips (sogenannte "bare dies") handeln kann, werden beispielsweise mithilfe von Klebstoff (nicht dargestellt) auf dem Befestigungsabschnitt 120 fixiert. Nach dem Aufbringen der Chips 140, 141 wird der Auswertechip 140 elektrisch mit dem Sensorchip 141 und mit der Leiterplatte 111 bzw. deren Leiterbahnen verbunden. Zu diesem Zweck wird ein Drahtbondverfahren durchgeführt, in dessen Verlauf Bonddrähte 150 an zugehörige Kontaktflächen bzw. Bondpads (nicht dargestellt) der Chips 140, 141 und des Befestigungsabschnitts 120 angeschlossen werden. Aufgrund des starren Befestigungsabschnitts 120 wird insbesondere eine Stabilisierung der Bonddrahtverbindungen zwischen dem Auswertechip 140 und dem Sensorchip 141 erzielt.

Um eine Korrosion der Kontaktflächen zu verhindern, können die Kontaktflächen bzw. die die Kontaktflächen aufweisenden Bereiche der Chips 140, 141 und des Befestigungsabschnitts 120 ferner nach dem Ausbilden der Bondrahtverbindungen mithilfe eines Versiegelungsmittels passiviert bzw. abgedeckt werden (nicht dargestellt). Als Versiegelungsmittel kann zum Beispiel ein Versiegelungsgel wie insbesondere Silikongel eingesetzt werden.

Der mikromechanische Sensorchip 141 ist zum Beispiel zum Erfassen einer Beschleunigung oder einer Drehrate ausgebildet. Zu diesem Zweck weist der Sensorchip 141 ein oder mehrere beweglich gelagerte Funktionselemente wie zum Beispiel Schwingerstrukturen auf (nicht dargestellt), deren Auslenkung beispielsweise auf kapazitive Weise erfasst wird. Der Auswertechip 140, welcher zum Steuern des Sensorchips 141 und zum Auswerten bzw. Weiterverarbeiten von Messsignalen des Sensorchips 141 dient, kann insbesondere als anwendungsspezifische integrierte Schaltung (ASIC, Application specific integrated circuit) ausgebildet sein.

Im Anschluss an das Aufbringen der Chips 140, 141 auf die flexible Leiterplatte 111, das Ausbilden der Bonddrahtverbindungen und gegebenenfalls das Passivieren der Kontaktstellen werden weitere Verfahrensschritte durchgeführt, um die in Figur 2 dargestellte Sensorvorrichtung 100 zu vervollständigen. Insbesondere wird die flexible Leiterplatte 111 in eine U-förmige Form mit zwei sich gegenüberliegenden und im Wesentlichen parallel zueinander angeordneten Schenkeln 118, 119 gebracht, welche einen Zwischenbereich einschließen. Der Befestigungsabschnitt 120 befindet sich dabei im Bereich des in Figur 2 dargestellten "oberen" Schenkels 118. In dem Zwischenbereich wird ein elastisches Dämpferelement 160 angeordnet, welches innenseitig an jedem der beiden Schenkel 118, 119 beispielsweise mithilfe von Klebstoff (nicht dargestellt) fixiert wird. Das Dämpferelement 160, durch welches eine Dämpfung der Chipstruktur ermöglicht wird, weist beispielsweise die Form eines Quaders auf.

Zur Herstellung einer derartigen Struktur können unterschiedliche Verfahren durchgeführt werden. Beispielsweise kann das Dämpferelement 160 ausgehend von der in Figur 1 dargestellten Anordnung zunächst mit einer Seite an der flexiblen Leiterplatte 111 (beispielsweise an dem späteren Schenkel 118 unterhalb der Chips 140, 141) befestigt werden. Anschließend kann die flexible Leiterplatte 111 in die U-Form versetzt werden, wobei das Dämpferelement 160 mit einer der zuerst fixierten Seite gegenüberliegenden Seite an der Leiterplatte 111 (bzw. an dem Schenkel 119) fixiert wird. Eine alternative Vorgehensweise besteht beispielsweise darin, die flexible Leiterplatte 111 in die U-Form zu biegen, wobei die dabei gebildeten Schenkel 118, 119 im Wesentlichen gleichzeitig an das Dämpferelement 160 angenähert und mit diesem innenseitig verbunden werden.

Die auf diese oder eine andere Weise hergestellte gedämpfte Sensorvorrichtung 100 kann auf weiteren Trägereinrichtungen befestigt und mit diesen elektrisch verbunden werden. Zur beispielhaften Veranschaulichung ist in Figur 2 eine starre Platine bzw. Leiterplatte 170 dargestellt, auf welcher die flexible Leiterplatte 111 bzw. deren "unterer" Schenkel 119 angeordnet ist. Um die flexible Leiterplatte 111 zuverlässig auf der Leiterplatte 170 zu fixieren, kann wie in Figur 2 dargestellt eine Klebstoffschicht 180 eingesetzt werden. Eine elektrische Verbindung zwischen den beiden Leiterplatten 111, 170 ist in Form einer Steckverbindung 130 angedeutet, welche mittels einander entsprechenden und an der Leiterplatte 170 und am Ende des Schenkels 119 der flexiblen Leiterplatte 111 vorgesehenen Kontaktelementen (z.B. Steckleisten) erzeugt werden kann.

Durch das Dämpferelement 160 ist der obere Schenkel 118 gegenüber dem auf der Leiterplatte 170 befestigten unteren Schenkel 119 und damit der Befestigungsabschnitt 120 gegenüber der Leiterplatte 170 elastisch auslenkbar. Auf diese Weise wird eine Dämpfung bzw. Entkopplung der Chipstruktur und insbesondere des mikromechanischen Sensorchips 141 gegenüber äußeren mechanischen Einflüssen wie zum Beispiel Stößen oder Vibrationen erzielt, wodurch sich hiermit verbundene Fehlfunktionen oder Beschädigungen vermeiden lassen.

Ein Vorteil gegenüber herkömmlichen Sensorvorrichtungen besteht darin, dass für das Dämpferelement 160 eine große Anzahl unterschiedlicher Materialien zur Auswahl steht. Dies liegt beispielsweise daran, da das Dämpferelement 160 lediglich an der flexiblen Leiterplatte 111 bzw. deren Schenkeln 118, 119 befestigt wird. Auch kann das Dämpferelement 160 getrennt von den anderen Komponenten der Sensorvorrichtung 100 hergestellt werden, so dass die Materialauswahl einschränkende Bedingungen wie insbesondere eine Spritzbarkeit entfallen können. Mögliche Dämpfermaterialien für das Dämpferelement 160 umfassen zum Beispiel Silikonmaterialien wie beispielsweise Flüssig-Silikon (auch als "liquid silicone rubber", LSR bezeichnet) oder auch andere elastische bzw. formbare Materialien wie insbesondere Gummimaterialien.

Durch die Wahl des Dämpfermaterials und der geometrischen Abmessungen des Dämpferelements 160 können die Dämpfungseigenschaften der Sensorvorrichtung 100 gezielt an gewünschte Anforderungen (zum Beispiel Störfrequenzen einer zu dämpfenden Vibration) angepasst werden. Eine in Betracht kommende Anwendung ist die Anordnung der auf der Platine 170 befestigten Sensorvorrichtung 100 in einem Gehäuse eines ABS-Steuergeräts, wobei im Betrieb des ABS-Steuergeräts auftretende Vibrationen oder Störbeschleunigungen mithilfe des Dämpferelements 160 zuverlässig gedämpft werden können.

Die auf der Leiterplatte 170 angeordnete Sensorvorrichtung 100 nimmt ferner aufgrund der "vertikalen" Übereinander-Anordnung von Chipstruktur 140, 141, Befestigungsabschnitt 120 und Dämpferelement 160 im Vergleich zu herkömmlichen Sensorvorrichtungen einen kleinen lateralen Platz in Anspruch. Die Verwendung der flexiblen Leiterplatte 111, über welche eine elektrische Verbindung zwischen der Chipstruktur bzw. dem Auswertechip 140 und anderen Komponenten wie der in Figur 2 dargestellten Leiterplatte 170 hergestellt werden kann, ermöglicht darüber hinaus eine hohe Fallfestigkeit und Stoßunempfindlichkeit. Zu diesem Zweck weist die flexible Leiterplatte 111 an der Basis der U-Form einen "freistehenden" Bereich auf, welcher nicht mit dem Dämpferelement 160 verbunden ist. Auf diese Weise können Abstandsänderungen zwischen dem Befestigungsabschnitt 120 und der Leiterplatte 170 bzw. zwischen den Schenkeln 118, 119, welche bei gedämpften Auslenkungen aufgrund von beispielsweise Stößen oder Vibrationen auftreten können, ausgeglichen werden, ohne dass die elektrische Verbindung unterbrochen oder beeinträchtigt würde.

Anhand der folgenden Figuren werden weitere Ausführungsformen von Sensorvorrichtungen erläutert, welche einen vergleichbaren oder ähnlichen Aufbau besitzen wie die in Figur 2 dargestellte Sensorvorrichtung 100. Im Hinblick auf Details, welche sich auf gleichartige oder übereinstimmende Komponenten, Verfahrensschritte zur Herstellung sowie mögliche Vorteile beziehen, wird daher auf die vorstehenden Ausführungen Bezug genommen.

Figur 3 zeigt eine weitere auf einer starren Leiterplatte 170 angeordnete Sensorvorrichtung 101, bei welcher als Chipstruktur anstelle von einzelnen ungehäusten Chips ein Chipmodul 145 direkt auf der flexiblen Leiterplatte 111 bzw. einem mit Kontaktstellen (nicht dargestellt) versehenen Befestigungsabschnitt 121 angeordnet ist. Das Chipmodul 145 umfasst ein Gehäuse (beispielsweise ein Standard Premold-Gehäuse), in welchem ein Auswertechip 140 und ein Sensorchip 141 angeordnet sind. Innerhalb des Gehäuses ist der Auswertechip 140 elektrisch mit dem Sensorchip 141 und mit Kontaktelementen des Chipmoduls 145 verbunden, beispielsweise über Bondrähte (nicht dargestellt). Die Kontaktelemente des Chipmoduls 145 sind weiter an zugehörige Kontaktstellen der flexiblen Leiterplatte 111 in dem Befestigungsabschnitt 121 angeschlossen (nicht dargestellt), worauf weiter unten näher eingegangen wird. Durch die Anordnung der Chips 140, 141 innerhalb des Gehäuses wird eine "Versteifung" erzielt, so dass der Befestigungsabschnitt 121 der flexiblen Leiterplatte 111, in bzw. auf welchem das Chipmodul 145 angeordnet wird, im Unterschied zu der Sensorvorrichtung 100 von Figur 2 nicht in Form eines starren Bereichs ausgebildet bzw. mit einer (zusätzlichen) starren Platte versehen ist.

Zum Aufbringen des Chipmoduls 145 auf die flexible Leiterplatte 111, was vor dem Versetzen der Leiterplatte 111 in die in Figur 3 dargestellte U-Form mit den Schenkeln 118, 119 und vor dem Anbringen des Dämpferelements 160 an der Leiterplatte 111 erfolgen kann, kann eine sogenannte SMD-Montagetechnik (Surface-mounted device) eingesetzt werden. Auf diese Weise lässt sich eine Befestigung des Chipmoduls 145 auf der flexiblen Leiterplatte 111 einschließlich Herstellen einer Kontaktierung zwischen dem Chipmodul 145 und der Leiterplatte 111 relativ einfach und schnell durchführen.

Eine Ausgestaltung besteht beispielsweise darin, auf einer Unterseite des Chipmoduls 145 bzw. dessen Gehäuse und auf dem Befestigungsabschnitt 121 der Leiterplatte 111 aufeinander abgestimmte Anordnungen von Anschlussflächen (land grid array, LGA) auszubilden, und diese durch ein Lötmittel elektrisch zu verbinden, was lediglich einen einfachen Lötvorgang erfordert. Statt eines Lötmittels kann auch ein leitfähiger Klebstoff zum Einsatz kommen. Möglich ist es auch, das Chipmodul 145 an der Unterseite mit einer Anordnung von Lötkugeln, beispielsweise in Form einer als "ball grid array" (BGA) bezeichneten Kugelgitteranordnung zu versehen, um das Chipmodul 145 durch Löten an Kontaktflächen der Leiterplatte 111 anzuschließen. Alternativ ist es vorstellbar, das Chipmodul 145 mit seitlichen Anschlusspins auszubilden, welche zugehörige Kontaktstellen der Leiterplatte 111 über ein Lötmittel oder einen leitfähigen Klebstoff kontaktieren können.

Der Aufbau der Sensorvorrichtung 101 von Figur 3 bietet die Möglichkeit, eine Dämpfung des Chipmoduls 145 nachträglich bzw. zusätzlich zu verwirklichen, wodurch eine hohe Flexibilität zur Verfügung gestellt wird. Das Chipmodul 145 kann insbesondere im Hinblick auf andere Parameter und Anforderungen als Dämpfungsanforderungen ausgebildet und optimiert sein. Insbesondere kann das Chipmodul 145 keine eigenen Dämpfungselemente umfassen. Sofern eine Dämpfungsfunktion gewünscht wird, weil das Chipmodul 145 beispielsweise für ESP-Anwendungen ausgebildet ist und in ein ABS-Steuergerät integriert werden soll, wodurch das Chipmodul 145 störenden Vibrationen ausgesetzt sein kann, kann die in Figur 3 dargestellte gedämpfte Vorrichtung 101 mit dem Chipmodul 145 hergestellt und auf der Leiterplatte 170 angeordnet werden.

SMD-Montagetechniken können auch bei der Montage einzelner Chips zum Einsatz kommen. Zur beispielhaften Veranschaulichung zeigt Figur 4 eine weitere auf einer Platine 170 angeordnete Sensorvorrichtung 102, bei welcher ungehäuste Chips, d.h. ein Auswertechip 140 und ein Sensorchip 141, auf der flexiblen Leiterplatte 111 angeordnet sind. Die Chips 140, 141 sind über Lötkugeln 151 an entsprechende Kontaktflächen (nicht dargestellt) der flexiblen Leiterplatte 111 angeschlossen und damit auf der Leiterplatte 111 befestigt. In dieser Ausgestaltung ist der Auswertechip 140 über die flexible Leiterplatte 111 elektrisch mit dem Sensorchip 141 verbunden.

Zur Montage der Chips 140, 141, welches erneut vor Versetzen der Leiterplatte 111 in die U-Form mit den Schenkeln 118, 119 erfolgen kann, kann beispielsweise ein sogenanntes "Flip-Chip"-Verfahren durchgeführt werden. Hierbei werden die Chips 140, 141 mit einer Kontaktierungsseite, auf welcher die Lötkugeln 151 ausgebildet sind, auf der flexiblen Leiterplatte 111 angeordnet, sowie ein Temperaturschritt durchgeführt, wodurch die Lötkugeln 151 aufschmelzen und eine elektrische Verbindung zwischen den Chips 140, 141 und Kontaktstellen der flexiblen Leiterplatte 111 hergestellt wird. Im Unterschied zu einem Drahtbondverfahren kann auf diese Weise eine Vielzahl an Kontakten gleichzeitig verbunden werden.

Bei der Sensorvorrichtung 102 ist der Befestigungsabschnitt 120 der Leiterplatte 111, auf welchem die Chips 140, 141 angeordnet sind, erneut starr ausgebildet. Zu diesem Zweck kann die Leiterplatte 111 beispielsweise eine starre Platte aufweisen, welche auf einer (flexiblen und Leiterbahnen umfassenden) Folie angeordnet ist. Die starre Platte kann zum Beispiel ein metallisches Material wie beispielsweise Stahl aufweisen und wie in Figur 4 angedeutet an derjenigen Seite der Leiterplatte 111 vorgesehen sein, welche der Seite der Leiterplatte 111 gegenüberliegt, auf welcher die Chips 140, 141 angeordnet sind. Hierbei kann wie in Figur 4 dargestellt ein Teil des Dämpferelements 160 am Rand seitlich über die starre Platte hinausragen bzw. die Platte seitlich umschließen.

Alternativ kann der steife Befestigungsabschnitt 120 auf andere Weise ausgebildet sein, wobei zum Beispiel die oben beschriebenen Ausgestaltungen in Betracht kommen können. Da eine elektrische Verbindung zwischen den Chips 140, 141 ohne Bonddrähte hergestellt ist, kann anstelle eines starren Befestigungsabschnitts 120 auch ein flexibler Abschnitt in Betracht kommen, auf welchem die Chips 140, 141 angeordnet sind.

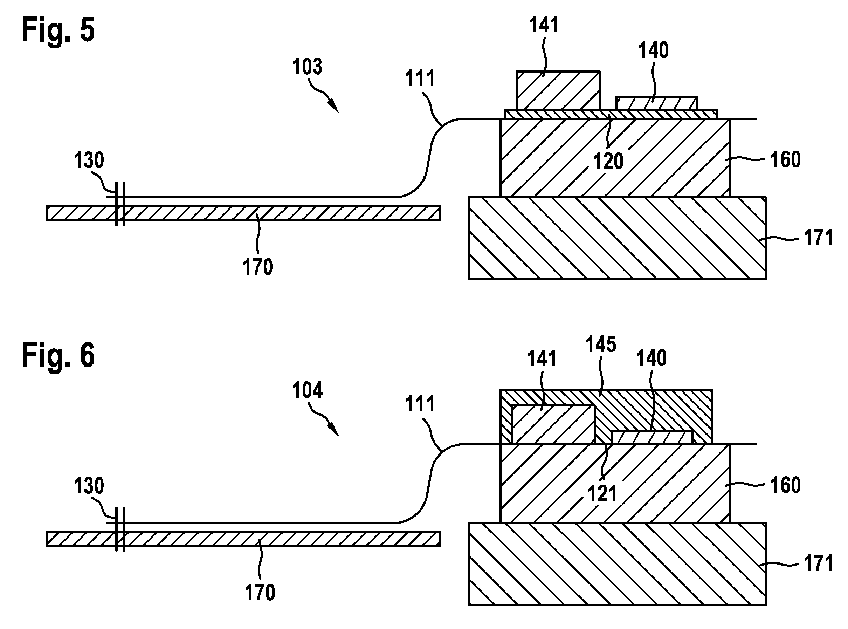

Figur 5 zeigt eine weitere mögliche Ausgestaltung einer Sensorvorrichtung 103. Die Sensorvorrichtung 103 weist eine flexible Leiterplatte 111 mit einem starren Befestigungsabschnitt 120 auf, auf welchem eine (ungehäuste) Chipstruktur mit einem Auswertechip 140 und einem Sensorchip 141 angeordnet ist. Die Chips 140, 141 können beispielsweise entsprechend der Sensorvorrichtung 100 von Figur 2 auf dem Befestigungsabschnitt 120 aufgeklebt und über Bonddrähte (nicht dargestellt) untereinander und mit der flexiblen Leiterplatte 111 elektrisch verbunden sein. Alternativ können die Chips 140, 141 entsprechend der Sensorvorrichtung 102 von Figur 4 über Lötkugeln (nicht dargestellt) auf dem Befestigungsabschnitt 120 befestigt sein, wobei die Montage im Rahmen eines SMD- bzw. Flip-Chip-Verfahrens erfolgen kann. In dieser Ausgestaltung kann die flexible Leiterplatte 111 auch ohne einen starren Befestigungsabschnitt 120 ausgebildet sein.

Im Unterschied zu den in den Figuren 2 bis 4 dargestellten Sensorvorrichtungen 100, 101, 102 ist die flexible Leiterplatte 111 bei der Sensorvorrichtung 103 von Figur 5 nicht in eine U-Form versetzt. Ein zur Dämpfung der Chipstruktur eingesetztes Dämpferelement 160 ist daher lediglich an einer Stelle an der flexiblen Leiterplatte 111 bzw. an dem Befestigungsabschnitt 120 in einem Bereich unterhalb der Chips 140, 141 befestigt. Dabei befinden sich die Chips 140, 141 und das Dämpferelement 160 an unterschiedlichen Seiten der flexiblen Leiterplatte 111 bzw. des Abschnitts 120. Hierbei kann das Dämpferelement 160 erneut über einen Klebstoff (nicht dargestellt) an der Leiterplatte 111 fixiert sein. Die Herstellung der Sensorvorrichtung 103 kann beispielsweise dadurch erfolgen, dass zunächst die Chips 140, 141 auf der flexiblen Leiterplatte 111 aufgebracht werden, wodurch eine Struktur entsprechend Figur 1 vorliegen kann, und nachfolgend das Dämpferelement 160 an der Leiterplatte 111 befestigt wird.

Die Sensorvorrichtung 103 kann wie in Figur 5 dargestellt mit dem Dämpferelement 160 weiter auf einer Trägereinrichtung 171 angeordnet und auf dieser beispielsweise mit Hilfe eines Klebstoffs (nicht dargestellt) fixiert werden. Die Trägereinrichtung 171 ist zum Beispiel ein Gehäuse bzw. ein Gehäuseabschnitt eines Steuergeräts, beispielsweise von einem ABS-System. Alternativ kann es sich bei der Trägereinrichtung 171 auch um eine separate Platine handeln. Des Weiteren kann die flexible Leiterplatte 111 elektrisch mit einer weiteren starren Leiterplatte 170 verbunden werden, wobei erneut wie in Figur 5 angedeutet eine Steckverbindung 130 vorgesehen werden kann. Die starre Leiterplatte 170 kann zum Beispiel ebenfalls in dem vorstehend beschriebenen Gehäuse eines Steuergeräts angeordnet sein.

Die Sensorvorrichtung 103 von Figur 5 bietet die Möglichkeit einer "Trennung" von gedämpfter Befestigung (auf der Trägereinrichtung 171) und elektrischer Kontaktierung (mit der Leiterplatte 170). Auf diese Weise kann beispielsweise ausgenutzt werden, dass sich die Trägereinrichtung 171 im Unterschied zu der Leiterplatte 170 als günstiger zum Befestigen der Sensorvorrichtung 103 erweist, weil beispielsweise weniger mechanische Störungen "erzeugt" werden, mehr Platz zur Verfügung steht und/oder eine bessere Haftung möglich ist. Die im Zusammenhang mit den oben beschriebenen Sensorvorrichtungen 100, 101, 102 genannten Vorteile sind auch bei der Sensorvorrichtung 103 von Figur 5 gegeben. Insbesondere nimmt die Sensorvorrichtung 103 aufgrund der "vertikalen" Übereinander-Anordnung von Chipstruktur 140, 141, Befestigungsabschnitt 120 und Dämpferelement 160 nur eine relativ kleine laterale Grundfläche auf der Trägereinrichtung 171 in Anspruch. Auch wird durch die flexible Leiterplatte 111 eine hohe Fallfestigkeit und Stoßunempfindlichkeit erzielt.

Figur 6 zeigt eine weitere Sensorvorrichtung 104, welche im Wesentlichen den gleichen Aufbau besitzt wie die Sensorvorrichtung 103 von Figur 5. Anstelle einer ungehäusten Chipstruktur weist die Sensorvorrichtung 104 jedoch ein gehäustes Chipmodul 145 mit einem Auswertechip 140 und einem Sensorchip 141 auf. Auch ist kein starrer Befestigungsabschnitt vorgesehen, so dass das Chipmodul 145 auf einem flexiblen Abschnitt bzw. Befestigungsabschnitt 121 der Leiterplatte 111 angeordnet ist. Hierbei sind das Chipmodul 145 und ein zur Dämpfung eingesetztes Dämpferelement 160 erneut auf unterschiedlichen Seiten der flexiblen Leiterplatte 111 angeordnet, wobei das Dämpferelement 160 unterhalb des Chipmoduls 145 vorgesehen ist.

Zur Herstellung der Sensorvorrichtung 104 können die oben beschriebenen Prozessschritte in entsprechender Weise durchgeführt werden. Insbesondere kann das Chipmodul 145 mit Hilfe einer SMD-Montagetechnik auf der Leiterplatte 111 angeordnet werden, was vor oder auch nach einem Befestigen des Dämpferelements 160 erfolgen kann. Wie in Figur 6 ferner dargestellt kann die Sensorvorrichtung 104 des Weiteren mit dem Dämpferelement 160 auf einer Trägereinrichtung 171 befestigt werden, und die flexible Leiterplatte 111 elektrisch mit einer (separaten) Platine 170 beispielsweise über eine Steckverbindung 130 verbunden werden.

Anstelle eine Chipstruktur und ein Dämpferelement wie bei den vorstehend beschriebenen Sensorvorrichtungen 100, 101, 102, 103, 104 auf unterschiedlichen Seiten einer flexiblen Leiterplatte 111 anzuordnen, können diese Komponenten auch auf der gleichen Seite einer flexiblen Leiterplatte 111 bzw. aneinander angrenzend vorgesehen sein. Hierzu zeigen die folgenden Figuren weitere Ausführungsformen von Sensorvorrichtungen. Hinsichtlich Details, welche sich auf gleichartige oder übereinstimmende Komponenten, Verfahrensschritte zur Herstellung sowie mögliche Vorteile beziehen, wird auf die vorstehenden Ausführungen verwiesen.

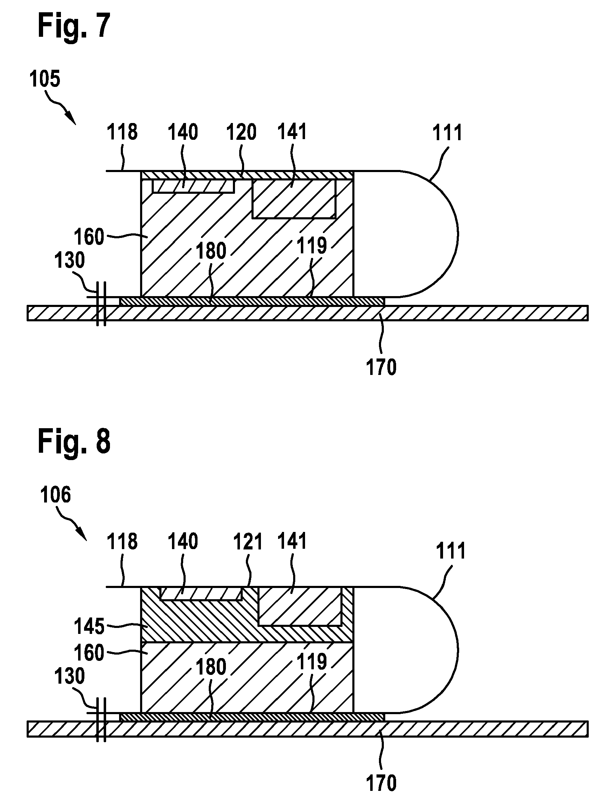

Figur 7 zeigt eine Sensorvorrichtung 105 mit einem solchen Aufbau. Die Sensorvorrichtung 105 weist eine U-förmige flexible Leiterplatte 111 mit zwei Schenkeln 118, 119 auf, welche einen Zwischenbereich einschließen. In dem Zwischenbereich ist auf bzw. an dem in Figur 7 dargestellten oberen Schenkel 118 eine (ungehäuste) Chipstruktur mit einem Auswertechip 140 und einem Sensorchip 141 angeordnet. Der Schenkel 118 weist hierbei einen starren Befestigungsbereich 120 auf.

In dem Zwischenbereich und angrenzend an die Chips 140, 141 ist ferner ein Dämpferelement 160 vorgesehen, welches die Chips 140, 141 zusätzlich umschließt, und daher auch zu einem Teil mit dem Befestigungsabschnitt 120 bzw. dem in Figur 7 dargestellten oberen Schenkel 118 verbunden ist. Neben dem oberen Schenkel 118 ist das Dämpferelement 160 weiter mit dem unteren Schenkel 119 verbunden. Durch das Umschließen bzw. Umkapseln der Chips 140, 141 kann das Dämpferelement 160 zusätzlich zu der Dämpferfunktion einen Schutz bzw. eine Passivierung der Chips 140, 141 bewirken.

Die Sensorvorrichtung 105 kann zum Beispiel dadurch hergestellt werden, dass zunächst die Chips 140, 141 entsprechend der oben beschriebenen Verfahren (Aufkleben und Drahtbonden oder SMD- bzw. Flip-Chip-Montage) auf der flexiblen Leiterplatte 111 angeordnet werden, wodurch beispielsweise eine Struktur entsprechend Figur 1 vorliegen kann, und nachfolgend das die Chips 140, 141 umschließende Dämpferelement 160 auf der Leiterplatte 111 ausgebildet wird. Zu diesem Zweck kann zum Beispiel ein geeignetes Dämpfermaterial in flüssiger bzw. zähflüssiger Form auf der Leiterplatte 111 im Bereich der Chips 140, 141 aufgebracht bzw. aufgespritzt werden. Nach einem Aushärten des Dämpfermaterials kann die Leiterplatte 111 in die U-Form versetzt und das ausgehärtete Dämpferelement 160 zum Beispiel durch Kleben mit dem dem Schenkel 118 gegenüberliegenden Schenkel 119 verbunden werden. Durch die Übereinander-Anordnung des Befestigungsabschnitts 120, der Chips 140, 141 und des (die Chips 140, 141 zu einem Teil umschließenden) Dämpferelements 160 weist die Sensorvorrichtung 105 ebenfalls eine kleine laterale Grundfläche auf.

Auch die gedämpfte Sensorvorrichtung 105 kann auf weiteren Trägereinrichtungen befestigt und mit diesen elektrisch verbunden werden. Figur 7 zeigt hierzu eine starre Platine 170, auf welcher die flexible Leiterplatte 111 bzw. deren Schenkel 119 mit Hilfe einer Klebstoffschicht 180 fixiert ist, wobei eine elektrische Verbindung zwischen den beiden Leiterplatten 111, 170 durch eine Steckverbindung 130 hergestellt ist.

Figur 8 zeigt eine weitere Sensorvorrichtung 106. Die Sensorvorrichtung 106 weist erneut eine U-förmige flexible Leiterplatte 111 mit zwei Schenkeln 118, 119 auf, welche einen Zwischenbereich einschließen. In dem Zwischenbereich ist auf bzw. an dem in Figur 8 dargestellten oberen Schenkel 118 ein gehäustes Chipmodul 145 mit einem Auswertechip 140 und einem Sensorchip 141 angeordnet. In dem Zwischenbereich ist angrenzend an das Chipmodul 145 ein Dämpferelement 160 vorgesehen, welches weiter mit dem unteren Schenkel 119 verbunden ist.

Die Sensorvorrichtung 106 kann zum Beispiel dadurch hergestellt werden, dass zunächst das Chipmodul 145 auf der flexiblen Leiterplatte 111 (durch Durchführen einer SMD-Montage) angeordnet wird, und nachfolgend das Dämpferelement 160 auf das Chipmodul 145 aufgebracht bzw. aufgeklebt wird. Die flexible Leiterplatte 111 weist hierbei keinen starren sondern einen flexiblen Befestigungsabschnitt 121 auf, da eine entsprechende Versteifung durch das Gehäuse des Chipmoduls 145 erzielt wird. Im Anschluss hieran kann die Leiterplatte 111 in die U-Form versetzt und das Dämpferelement 160 (zum Beispiel durch Kleben) mit dem dem Schenkel 118 gegenüberliegenden Schenkel 119 verbunden werden. Die auf diese Weise hergestellte gedämpfte Sensorvorrichtung 106 kann auf weiteren Trägereinrichtungen befestigt und mit diesen elektrisch verbunden werden, wie in Figur 8 erneut anhand der Platine 170 veranschaulicht ist.

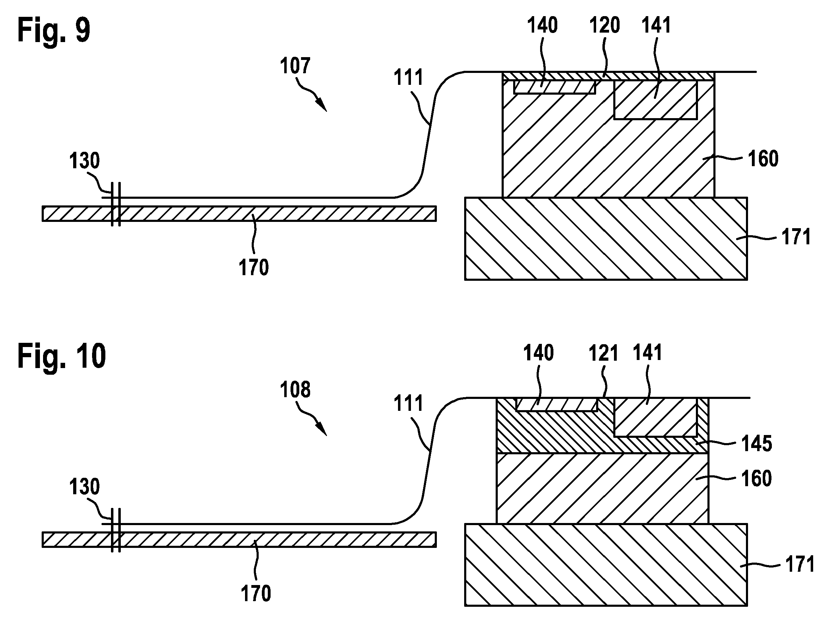

Figur 9 zeigt eine weitere Sensorvorrichtung 107, bei welcher entsprechend der Sensorvorrichtung 105 von Figur 7 auf einem Befestigungsabschnitt 120 einer flexiblen Leiterplatte 111 ungehäuste Chips 140, 141, und zusätzlich ein die Chips 140, 141 umschließendes Dämpferelement 160 vorgesehen ist. Zur Ausbildung des Dämpferelements 160 können die im Zusammenhang mit der Sensorvorrichtung 105 angegebenen Verfahrensschritte durchgeführt werden.

Die flexible Leiterplatte 111 ist bei der Sensorvorrichtung 107 von Figur 9 jedoch im Unterschied zu der Sensorvorrichtung 105 nicht in eine U-Form versetzt. Die Sensorvorrichtung 107 kann daher entsprechend der Sensorvorrichtung 103 von Figur 5 mit dem Dämpferelement 160 auf einer Trägereinrichtung 171 angeordnet bzw. befestigt werden. Auch kann eine elektrische Verbindung zwischen der flexiblen Leiterplatte 111 und einer von der Trägereinrichtung 171 separaten Platine 170 beispielsweise über eine Steckverbindung 130 hergestellt werden.

Figur 10 zeigt eine weitere Sensorvorrichtung 108, bei welcher entsprechend der Sensorvorrichtung 106 von Figur 8 auf einer flexiblen Leiterplatte 111 ein Chipmodul 145, und angrenzend an das Chipmodul 145 ein Dämpferelement 160 vorgesehen ist. Die flexible Leiterplatte 111 ist jedoch abweichend von der Sensorvorrichtung 106 nicht in eine U-Form versetzt, so dass die Sensorvorrichtung 108 entsprechend der Sensorvorrichtung 104 von Figur 6 mit dem Dämpferelement 160 auf einer Trägereinrichtung 171 angeordnet werden kann. Auch kann eine elektrische Verbindung zwischen der flexiblen Leiterplatte 111 und einer von der Trägereinrichtung separaten Platine 170 beispielsweise über eine Steckverbindung 130 hergestellt werden.

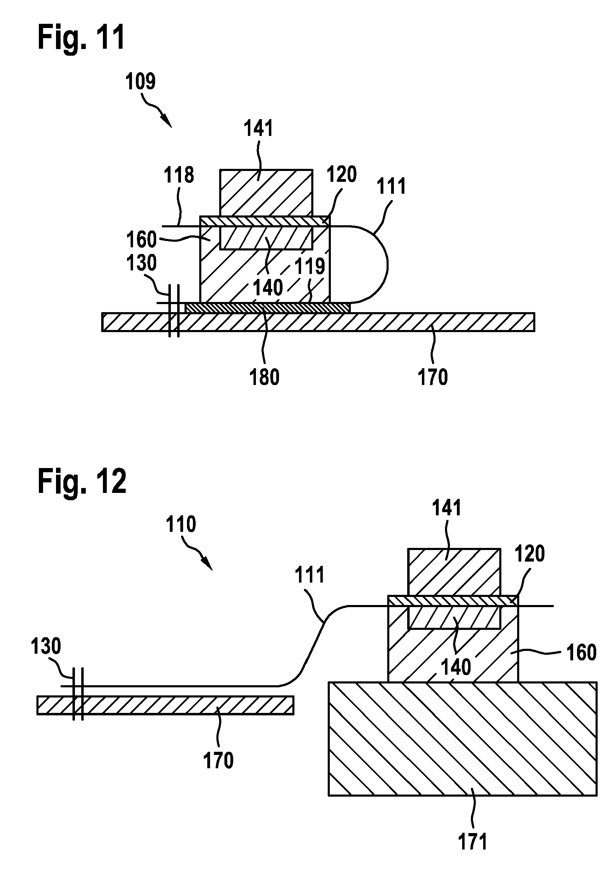

Anstelle Chips auf der gleichen Seite einer flexiblen Leiterplatte 111 vorzusehen, besteht alternativ die Möglichkeit einer Anordnung auf unterschiedlichen Seiten. In dieser Hinsicht zeigt Figur 11 eine weitere Sensorvorrichtung 109 mit einem Auswertechip 140 und einem Sensorchip 141. Die beiden Chips 140, 141 sind auf unterschiedlichen Seiten auf einem starren Befestigungsabschnitt 120 der flexiblen Leiterplatte 111 angeordnet.

Die Chips 140, 141 können beispielsweise auf dem Befestigungsabschnitt 120 aufgeklebt und über Bonddrähte (nicht dargestellt) mit Kontaktsellen der flexiblen Leiterplatte 111 elektrisch verbunden sein. Alternativ können die Chips 140, 141 auch über ein SMD- bzw. Flip-Chip-Verfahren auf dem Befestigungsabschnitt 120 angeordnet sein, wobei Lötkugeln (nicht dargestellt) zum Einsatz kommen können. Über den Befestigungsabschnitt 120 bzw. eine in dem Befestigungsabschnitt 120 vorgesehene Kontakt- bzw. Umverdrahtungsstruktur sind die beiden Chips 140, 141 elektrisch miteinander verbunden.

Die flexible Leiterplatte 111 weist erneut eine U-förmige Form mit zwei Schenkeln 118, 119 auf, welche einen Zwischenbereich einschließen, in welchem auch der Auswertechip 140 angeordnet ist. In dem Zwischenbereich und angrenzend an den Auswertechip 140 ist ein Dämpferelement 160 vorgesehen, welches den Auswertechip 140 zusätzlich umschließt, und daher auch zu einem Teil mit dem Befestigungsabschnitt 120 bzw. dem in Figur 11 dargestellten oberen Schenkel 118 verbunden ist. Neben dem oberen Schenkel 118 ist das Dämpferelement 160 weiter mit dem unteren Schenkel 119 verbunden. Durch diese Übereinander-Anordnung des Sensorchips 141, des Befestigungsabschnitts 120, des Auswertechips 140 und des (den Chip 140 zum Teil umschließenden) Dämpferelements 160 wird ein (lateral) platzsparender Aufbau weiter begünstigt.

Die Sensorvorrichtung 109 kann zum Beispiel dadurch hergestellt werden, dass zunächst die Chips 140, 141 auf unterschiedlichen Seiten der flexiblen Leiterplatte 111 angeordnet werden, nachfolgend das den Auswertechip 140 umschließende Dämpferelement 160 auf der Leiterplatte 111 ausgebildet wird (z.B. durch Aufbringen eines Dämpfermaterials in flüssiger bzw. zähflüssiger Form und Aushärten), und anschließend die Leiterplatte 111 in die U-Form versetzt wird, wobei das Dämpferelement 160 zum Beispiel durch Kleben mit dem dem Schenkel 118 gegenüberliegenden Schenkel 119 verbunden wird. Die auf diese Weise hergestellte Sensorvorrichtung 109 kann auf einer weiteren Trägereinrichtung befestigt und mit dieser elektrisch verbunden werden, wie in Figur 11 anhand der starren Platine 170 dargestellt ist.

Figur 12 zeigt eine weitere Sensorvorrichtung 110, bei welcher entsprechend der Sensorvorrichtung 109 von Figur 11 auf unterschiedlichen Seiten eines Befestigungsabschnitt 120 einer flexiblen Leiterplatte 111 ein Auswertechip 140 und ein Sensorchip 141 angeordnet sind, und zusätzlich ein den Auswertechip 140 umschließendes Dämpferelement 160 vorgesehen ist. Die flexible Leiterplatte 111 ist jedoch nicht in eine U-Form versetzt. Infolgedessen kann die Sensorvorrichtung 111 mit dem Dämpferelement 160 auf einer Trägereinrichtung 171 angeordnet werden. Eine elektrische Verbindung kann zwischen der flexiblen Leiterplatte 111 und einer von der Trägereinrichtung 171 separaten Platine 170 beispielsweise über eine Steckverbindung 130 hergestellt werden.

Die anhand der Figuren erläuterten Ausführungsformen von Sensorvorrichtungen sowie Verfahren zu deren Herstellung stellen bevorzugte bzw. beispielhafte Ausführungsformen der Erfindung dar. Neben den beschriebenen und abgebildeten Ausführungsformen sind weitere Ausführungsformen vorstellbar, welche weitere Abwandlungen bzw. Kombinationen von Merkmalen umfassen können. Beispielsweise können die in den Figuren 11 und 12 dargestellten Sensorvorrichtungen 109, 110 derart abgewandelt werden, dass das jeweilige Dämpferelement 160 anstelle des Auswertechips 140 auf dem Sensorchip 141 angeordnet ist und diesen umschließt. In Bezug auf die in den Figuren 5, 6, 9, 10, 12 dargestellten Sensorvorrichtungen 103, 104, 107, 108, 110, bei denen die flexible Leiterplatte 111 nicht in einer U-Form vorliegt, besteht die Möglichkeit, eine gemeinsame Trägereinrichtung zu verwenden, auf welcher sowohl das Dämpferelement 160 angeordnet und mit welcher die flexible Leiterplatte 111 elektrisch verbunden wird.

Eine weitere Variante besteht darin, auch bei Verwendung eines Chipmoduls 145 eine flexible Leiterplatte 111 mit einem starren Befestigungsabschnitt 120 zu verwenden, auf welchem das Chipmodul 145 angeordnet wird. Hinsichtlich der in den Figuren dargestellten Steckverbindungen 130 können andere Verbindungen bzw. Standardverbindungen zum Herstellen einer elektrischen Kontaktierung vorgesehen sein.

Darüber hinaus sind Sensorvorrichtungen vorstellbar, welche eine andere Anzahl an Chips aufweisen. Ein Beispiel ist eine Sensorvorrichtung mit einem Auswertechip und drei Sensorchips, um Beschleunigungen in drei zueinander senkrechten Raumrichtungen zu erfassen. Auch hierbei kommen unterschiedliche Ausgestaltungen in Betracht, d.h. beispielsweise dass die Chips als ungehäuste Chips oder in einem Chipmodul vorgesehen sein können, dass sämtliche Chips auf einer Seite einer flexiblen Leiterplatte oder auf unterschiedlichen Seiten angeordnet sein können, dass ein Dämpferelement auf der gleichen Seite der Leiterplatte wie die Chips (oder ein Teil der Chips) oder auf einer gegenüberliegenden Seite angeordnet sein kann, usw.

Anstelle ein Dämpferelement separat herzustellen und das Dämpferelement auf eine flexible Leiterplatte oder ein Chipmodul aufzukleben, kann ein Dämpferelement (entsprechend den Sensorvorrichtungen 105, 107, 109, 110) auch durch beispielsweise Aufbringen in flüssiger bzw. zähflüssiger Form und Aushärten bereitgestellt werden. Ferner wird ergänzend darauf hingewiesen, dass die genannten Materialien für Komponenten der Sensorvorrichtungen lediglich als Beispiele anzusehen sind, welche gegebenenfalls durch andere Materialien ersetzt werden können.

## Patentansprüche

1. Sensorvorrichtung, aufweisend:
- eine flexible Leiterplatte (111) mit einem Befestigungsabschnitt (120, 121) für eine Chipstruktur (140, 141, 145);
- eine auf dem Befestigungsabschnitt (120, 121) der flexiblen Leiterplatte (111) angeordnete Chipstruktur (140, 141, 145); und
- ein Dämpferelement (160) zum Dämpfen der Chipstruktur (140, 141, 145) gegenüber mechanischen Einflüssen,
wobei der Befestigungsabschnitt (120, 121) der flexiblen Leiterplatte (111), die Chipstruktur (140, 141, 145) und das Dämpferelement (160) zueinander übereinander angeordnet sind,
wobei die flexible Leiterplatte (111) im Querschnitt eine U-förmige Form mit einem ersten und einem zweiten Schenkel (118, 119) aufweist, welche einen Zwischenbereich einschließen,
wobei das Dämpferelement (160) in dem Zwischenbereich angeordnet ist, und
wobei die flexible Leiterplatte (111) an der Basis der U-förmigen Form einen freistehenden Bereich aufweist, welcher nicht mit dem Dämpferelement (160) verbunden ist.

2. Sensorvorrichtung nach Anspruch 1, wobei die flexible Leiterplatte (111) eine erste Seite und eine der ersten Seite gegenüberliegende zweite Seite aufweist, wobei die Chipstruktur (140, 141, 145) auf der ersten Seite und das Dämpferelement (160) auf der zweiten Seite der flexiblen Leiterplatte (111) angeordnet ist.

3. Sensorvorrichtung nach Anspruch 1, wobei das Dämpferelement (160) an die Chipstruktur (140, 141, 145) angrenzt.

4. Sensorvorrichtung nach Anspruch 3, wobei das Dämpferelement die Chipstruktur (140, 141) zusätzlich umschließt.

5. Sensorvorrichtung nach Anspruch 1, wobei das Dämpferelement (160) und die Chipstruktur (140, 141, 145) in dem Zwischenbereich angeordnet sind.

6. Sensorvorrichtung nach einem der vorhergehenden Ansprüche, wobei der Befestigungsabschnitt ein starrer Abschnitt (120) der flexiblen Leiterplatte ist.

7. Sensorvorrichtung nach einem der vorhergehenden Ansprüche, wobei die Chipstruktur eine der folgenden Komponenten umfasst:
- einen Sensorchip (140) und einen Auswertechip (141); oder
- ein Chipmodul (145).

8. Verfahren zum Herstellen einer Sensorvorrichtung nach einem der vorhergehenden Ansprüche mit den Schritten:
- Bereitstellen einer flexiblen Leiterplatte (111), wobei die flexible Leiterplatte einen Befestigungsabschnitt (120, 121) für eine Chipstruktur (140, 141, 145) aufweist;
- Anordnen einer Chipstruktur (140, 141, 145) auf dem Befestigungsabschnitt (120, 121) der flexiblen Leiterplatte (111);
- Bringen der flexiblen Leiterplatte (111) in eine im Querschnitt U-förmige Form mit einem ersten und einem zweiten Schenkel (118, 119), welche einen Zwischenbereich einschließen; und
- Ausbilden eines Dämpferelements (160) derart, dass der Befestigungsabschnitt (120, 121) der flexiblen Leiterplatte (111), die Chipstruktur (140, 141, 145) und das Dämpferelement (160) zueinander übereinander und das Dämpferelement (160) in dem Zwischenbereich angeordnet sind, und dass die flexible Leiterplatte (111) an der Basis der U-förmigen Form einen freistehenden Bereich aufweist, welcher nicht mit dem Dämpferelement (160) verbunden ist.

## Claims

1. Sensor device, comprising:
- a flexible printed circuit board (111) having a fastening section (120, 121) for a chip structure (140, 141, 145) ;
- a chip structure (140, 141, 145) arranged on the fastening section (120, 121) of the flexible printed circuit board (111); and
- a damper element (160) for damping the chip structure (140, 141, 145) from mechanical influences;
wherein the fastening section (120, 121) of the flexible printed circuit board (111), the chip structure (140, 141, 145) and the damper element (160) are arranged one over the other,
wherein the flexible printed circuit board (111) has in cross section a U-shaped form with a first leg (118) and a second leg (119), which enclose an intermediate area,
wherein the damper element (160) is arranged in the intermediate area, and
wherein the flexible printed circuit board (111) has at the base of the U-shaped form a free area that is not connected to the damper element (160).

2. Sensor device according to Claim 1, wherein the flexible printed circuit board (111) has a first side and a second side that is opposite from the first side, wherein the chip structure (140, 141, 145) is arranged on the first side and the damper element (160) is arranged on the second side of the flexible printed circuit board (111).

3. Sensor device according to Claim 1, wherein the damper element (160) borders on the chip structure (140, 141, 145).

4. Sensor device according to Claim 3, wherein the damper element additionally encloses the chip structure (140, 141).

5. Sensor device according to Claim 1, wherein the damper element (160) and the chip structure (140, 141, 145) are arranged in the intermediate area.

6. Sensor device according to one of the preceding claims, wherein the fastening section is a rigid section (120) of the flexible printed circuit board.

7. Sensor device according to one of the preceding claims, wherein the chip structure comprises one of the following components:
- a sensor chip (140) and an evaluation chip (141); or
- a chip module (145).

8. Method for producing a sensor device according to one of the preceding claims with the steps of:
- providing a flexible printed circuit board (111), wherein the flexible printed circuit board has a fastening section (120, 121) for a chip structure (140, 141, 145);
- arranging a chip structure (140, 141, 145) on the fastening section (120, 121) of the flexible printed circuit board (111);
- bringing the flexible printed circuit board (111) into a cross-sectionally U-shaped form with a first leg (118) and a second leg (119), which enclose an intermediate area; and
- forming a damper element (160) in such a way that the fastening section (120, 121) of the flexible printed circuit board (111), the chip structure (140, 141, 145) and the damper element (160) are arranged in relation to one another one over the other and the damper element (160) is arranged in the intermediate area, and in that the flexible printed circuit board (111) has at the base of the U-shaped form a free area that is not connected to the damper element (160).

## Revendications

1. Dispositif capteur, comprenant :
- une carte de circuit imprimé flexible (111) pourvue d'une section de fixation (120, 121) pour une structure de puce (140, 141, 145) ;
- une structure de puce (140, 141, 145) disposée sur la section de fixation (120, 121) de la carte de circuit imprimé flexible (111) ; et
- un élément amortisseur (160) destiné à amortir la structure de puce (140, 141, 145) vis-à-vis d'influences mécaniques,
dans lequel la section de fixation (120, 121) de la carte de circuit imprimé flexible (111), la structure de puce (140, 141, 145) et l'élément amortisseur (160) sont disposés les uns au-dessus des autres,
dans lequel la carte de circuit imprimé (111) présente une forme en U en section transversale ayant des première et seconde articulations (118, 119) qui délimitent une région intermédiaire,
dans lequel l'élément amortisseur (160) est disposé dans la région intermédiaire, et
dans lequel la carte de circuit imprimé flexible (111) présente, à la base de la forme en U, une région dégagée qui n'est pas reliée à l'élément amortisseur (160).

2. Dispositif capteur selon la revendication 1, dans lequel la carte de circuit imprimé flexible (111) présente une première face et une seconde face opposée à la première face, dans lequel la structure de puce (140, 141, 145) est disposée sur la première face et l'élément amortisseur (160) est disposé sur la seconde face de la carte de circuit imprimé flexible (111).

3. Dispositif capteur selon la revendication 1, dans lequel l'élément amortisseur (160) est adjacent à la structure de puce (140, 141, 145).

4. Dispositif capteur selon la revendication 3, dans lequel l'élément amortisseur enserre en outre la structure de puce (140, 141).

5. Dispositif capteur selon la revendication 1, dans lequel l'élément amortisseur (160) et la structure de puce (140, 141, 145) sont disposés dans la région intermédiaire.

6. Dispositif capteur selon l'une quelconque des revendications précédentes, dans lequel la section de fixation est une section rigide (120) de la carte de circuit imprimé flexible.

7. Dispositif capteur selon l'une quelconque des revendications précédentes, dans lequel la structure de puce comprend l'un des composants suivants :
- une puce de capteur (140) et une puce de traitement (141) ; ou
- un module de puce (145).

8. Procédé de fabrication d'un dispositif capteur selon l'une quelconque des revendications précédentes, comportant les étapes consistant à :
- fournir une carte de circuit imprimé flexible (111), dans lequel la carte de circuit imprimé flexible comprend une section de fixation (120, 121) pour une structure de puce (140, 141, 145) ;
- disposer une structure de puce (140, 141, 145) sur la section de fixation (120, 121) de la carte de circuit imprimé flexible (111) ;
- amener la carte de circuit imprimé flexible (111) à présenter une forme en U en section transversale ayant des première et seconde articulations (118, 119) qui délimitent une région intermédiaire ; et
- réaliser l'élément amortisseur (160) de manière à ce que la section de fixation (120, 121) de la carte de circuit imprimé flexible (111), la structure de puce (140, 141, 145) et l'élément amortisseur (160) soient disposés les uns au-dessus des autres dans la région intermédiaire, et à ce que la carte de circuit imprimé flexible (111) présente à la base de la forme en U une région dégagée qui n'est pas reliée à l'élément amortisseur (160).
